# EUROPEAN PATENT SPECIFICATION

(11) **EP 1 540 814 B1**
(45) Date of publication and mention of the grant of the patent: **04.08.2010**
(21) Application number: 03765113.0
(22) Date of filing: 25.06.2003
(51) Int. Cl.: H03D 7/16

(54) **VHF ADAPTER FOR CABLE NETWORK**
VHF-ADAPTER FÜR EIN KABELNETZWERK
ADAPTATEUR VHF POUR RESEAU CABLE

(30) Priority: 10.07.2002 FR 0208939
(43) Date of publication of application: 15.06.2005
(73) Proprietor: Thomson Licensing, 92130 Issy-les-Moulineaux (FR)
(72) Inventor: ROBERT, Jean-Luc, F-35830 Betton (FR); LE NAOUR, Jean-Yves, F-35740 Pace (FR); GUGUEN, Charline, F-35700 Rennes (FR)
(74) Representative: Rossmanith, Manfred
(86) International application number: PCT/EP2003/050260
(87) International publication number: WO 2004/010574

(56) References cited:
- EP-A2- 1 168 641
- WO-A-98/10511
- FR-A- 2 815 505
- GB-A- 2 292 502
- US-A- 5 794 119
- US-A- 5 844 939
- US-B1- 6 324 379
- US-B1- 6 363 241

## Description

The present invention concerns VHF adapters, commonly called ODUs (standing for "Outdoor Units"), intended more particularly for receiving by radio the signals originating from a base station fed from a cable network, so as to transmit these signals to an application terminal, especially a video or data terminal. This ODU unit is exterior to the application terminal.

Recent years have witnessed the emergence of point-multipoint distribution systems for a large number of millimetre frequency bands. The earliest studies related only to analogue broadcasting systems whereas nowadays it is digital systems offering interactive services that are in the forefront.

The term "Multimedia Wireless System: WMS" has been chosen to designate all systems which provide for convergence between the world of broadcasting and the world of telecommunications and which deliver broadband wireless access to the subscriber for multimedia services. These systems require a great deal of bandwidth and the 40 GHz (40.5-43.5 GHz) band has been designated in Europe for such systems.

It is recalled that RF transmission systems of point-multipoint type are known to the person skilled in the art by the initials MMDS (standing for Microwave Multipoint Distribution System), LMDS (standing for Local Multipoint Distribution System) and MVDS (standing for Multipoint Video Distribution System). These systems used for the broadcasting of programmes permit a return path to the subscriber terminals which allows the subscriber to interact with the programme received.

In Europe, it is planned to implement an LMDS type system which has 24 broadcasting channels (also called downlinks) having a bandwidth of 33 MHz, and 25 return channels (or uplinks) having a bandwidth of 2 MHz, these channels being situated between 40.5 and 42.5 GHz (for further details about the apportioning of these channels, the person skilled in the art may consult the MPT-1560-RA standard).

The system implemented must comply with the ETSI 301199 standard better known by the name LMDS DVB which among other things provides for an oscillator drift of plus or minus 200 kHz for the uplink, the drift being due mainly to climatic conditions. For further information about these systems, the person skilled in the art may refer for example to patent application WO 2002/33855.

The bandwidth allotted for this type of application has been increased and currently corresponds to the frequency band lying between 40.5 and 43.5 GHz as stated hereinabove. It is also planned to segment this band so as to apportion it between several operators.

The present invention pertains to the general framework of these transmission systems.

Specifically, one seeks to use a wireless communication system of the MWS or LMDS type to plug into an existing cable network, a video and/or data terminal which can normally be plugged directly into this network. To do this, the MWS system must be transparent in relation to the cable network and hence comply with the constraints set by the standard, of the DOCSIS type (standing for "Data Over Cable Service Interface Specification") or EuroDOCSIS type for example, used in regard to this cable network.

These constraints are very severe for a terminal operating in the millimetre frequency bands used in MWS systems, typically 40.5-43.5 GHz, especially in terms of frequency stability and phase noise.

In order for a millimetre MWS ODU unit to meet the DOCSIS standard, it must comply with the following technical constraints:
- Provide IF (standing for Intermediate Frequencies) accesses at 91 MHz / 857 MHz for the down channels, and 5 MHz / 65 MHz for the up channels;
- satisfy the frequency stability and phase noise constraints of the cable standard, which are already severe in themselves on account of the high-order QAM type modulations used, at millimetre frequencies;
- not perform spectral inversion of the signal transmitted or received.

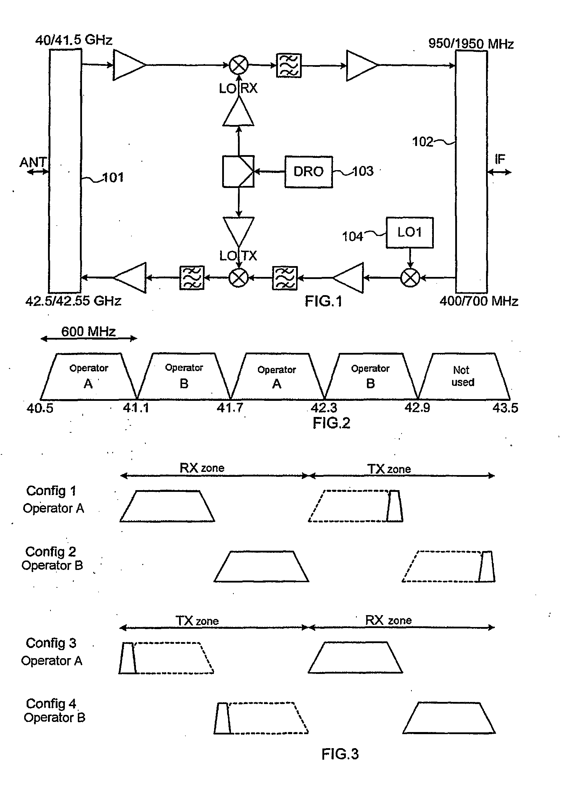

The structure of a conventional MWS ODU unit is represented in Figure 1. It uses between an antenna appliance 101 and an intermediate frequency (IF) output multiplexer 102 two conversion chains of known type making it possible to obtain the IF for down reception RX at 950/1950 MHz, and the IF for up transmission TX at 400/700 MHz. To do this, use is made of a local oscillator 103 of DRO type (dielectric resonator oscillator) common to the two conversion chains to go from the 40 GHz range to the 1000 MHz range, and a local oscillator LO1 104 of ordinary type on the up chain to obtain the desired frequency gap.

This structure is simple and cheap, but it does not make it possible to comply with the technical constraints cited above, or to obtain the various frequency plans of the DOCSIS standard with a single embodiment.

To comply with these constraints and obtain a multimode single version of the ODU with this architecture, it would be necessary to complicate the Latter in such a way that it would lead to an unacceptable overhead cost.

GB 2 292 502 A also describes a transmitter/receiver circuit for one station of a microwave radio system, comprising one signal path for up converting a signal from an antenna and a second signal path for down converting a signal received on the antenna. A single local oscillator is used to provide the signals for the up conversion and the down conversion. A separated local oscillator is provided.

The invention proposes a VHF adapter for cable network, of the type comprising a first down conversion chain and a second up conversion chain, wherein the first chain comprises a first mixer followed by a second mixer and the second chain a third mixer followed by a fourth and by a fifth mixer, and wherein that all the local frequencies necessary for these five mixers are obtained from a very stable single reference oscillator.

The single reference oscillator drives a harmonics generator inserted into a phase loop dielectric resonator oscillator using an SPD (Sample Phase Detector) system to obtain on the one hand, possibly after multiplication by two, a first local frequency energizing the first and fifth mixers, and on the other hand with a first surface wave filter filtering of a particular harmonic a second local frequency for energizing the second and the fourth mixers.

According to another characteristic, the single reference oscillator furthermore drives an agile frequency synthesizer controlled by a bus so as to obtain variable frequencies for energizing the fourth mixer; and in that a second surface wave filter is placed between the output of the third mixer and an input of the fourth mixer so that, the intermediate frequency for energizing the third mixer being a very low frequency pure frequency, the signal delivered by this third mixer can be filtered by the second surface wave filter which energetically rejects the second local frequency and the image-frequency signal.

According to another characteristic, the frequency plan of the various mixers makes it possible to obtain by simple switching of the frequencies of the harmonics generator and of the agile synthesizer and by a single change of the surface wave filters, four configurations for two distinct operators compatible with a cable network.

The subject of the invention is also a radio-frequency transmission system comprising at least one base station and at least one subscriber device, the base station using a single oscillator to perform a down conversion of signals to the frequency band transmitted by radio and an up conversion of signals from the frequency band received by radio, the subscriber device comprising an interior unit and an exterior unit which are linked by a cable, principally **characterized in that** the exterior unit comprises a VHF adapter as defined above.

Other features and advantages of the invention will become clearly apparent in the following description, presented by way of nonlimiting example with regard to the appended figures which represent:
- Figure 1, the diagram of a known architecture of an ODU;
- Figure 2, the spectral apportioning of the frequencies for an MWS system at 40 GHz;
- Figure 3, the four possible configurations between two operators in the apportionment of Figure 2;
- Figure 4, the diagram of an architecture of an ODU according to the invention;
- Figures 5 and 6, two simplified schematic diagrams corresponding to the two basic configurations contained in the four configurations of Figure 3; and
- Figure 7, an exemplary architecture of the means for generating the VHF and IF local frequencies;
- Figure 8, a distribution system using the invention.

A spectral apportioning, represented in Figure 2, of the frequencies which is usable for a 40 GHz MWS system makes it possible to obtain for two operators, A and B, the four configurations represented in Figure 3.

In the first two configurations, the down reception for the two operators is carried out at the bottom of the bands of the bottom zone A and the up transmission is carried out at the top of the bands of the top zone B.

The apportionment is reversed in the last two configurations.

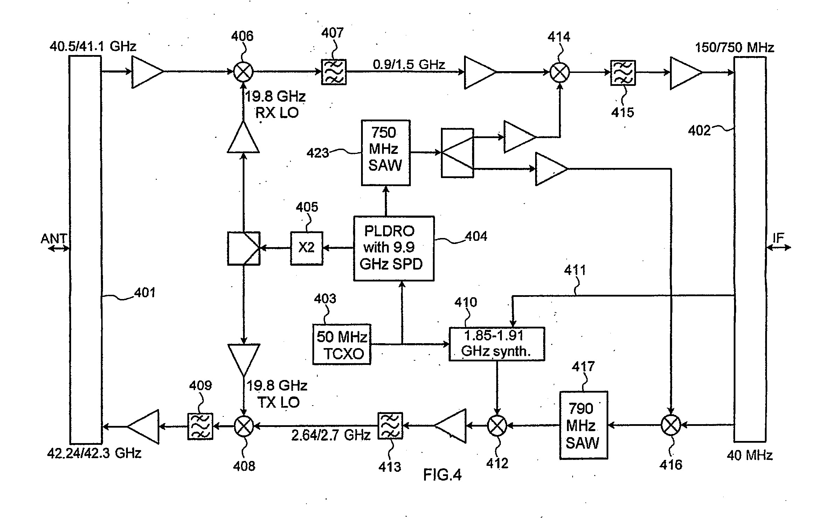

The diagram of an architecture of an ODU unit according to the invention is represented in Figure 4 with as an example, the numerical values of the frequencies in the case of configuration 1.

An antenna appliance 401 receives the VHF down frequencies 40.5 to 41.1 GHz and up frequencies 42.24 to 42.3 GHz.

Two conversion chains link this appliance 401 to a multiplexer 402 which delivers the intermediate frequencies, down lying between 150 and 750 MHz and up corresponding to a channel centred at 40 MHz.

The stability and purity of the local frequencies necessary for these conversion chains are ensured through the use of a single local oscillator 403 with 50 MHz TCXO type crystal to generate the reference frequency which drives all these frequencies.

This oscillator 403 firstly drives a harmonics generator 404 inserted into an oscillator of the phase loop dielectric resonator type (PLDRO) using an SPD (standing for "Sampling Phase Detector") system.

This harmonics generator makes it possible to obtain firstly a local frequency at 9.9 GHz which is then multiplied by two in a multiplier 405 to obtain a frequency at 19800 MHz.

A mixer 406 followed by a filter 407 then makes it possible to obtain in the down chain the second infradyne product at 900/1500 MHz.

Likewise, a mixer 408 followed by a filter 409 makes it possible to obtain in the up chain the second supradyne product at 42.3/42.24 GHz.

The mixers 406 and 408 are VHF mixers performing a sub-harmonic conversion of order 2.

The oscillator 403 also drives an agile frequency synthesizer 410 controlled from the multiplexer 402 by a bus 411 so as to obtain variable frequencies between 1.85 and 1.91 GHz. These frequencies make it possible, with the aid of a mixer 412 and of a filter 413, to obtain the up frequencies 2.64/2.7 GHz applied to the mixer 408, from the first up IF with carrier frequency 790 MHz.

A filter 423 makes it possible to obtain from the harmonics generator 404 a local frequency of 750 MHz. This very narrow filter is of the surface wave type (SAW) so as to obtain a very pure frequency.

From this frequency, a mixer 414 and a filter 415 make it possible to obtain the final down IF at 150/750 MHz.

Likewise, a mixer 416 and a filter 417 make it possible from the up IF at the carrier frequency of 40 MHz to obtain the said carrier frequency at 790 MHz. This filter 417 is of the SAW type, hence very selective, so as to energetically reject the local frequency at 750 MHz. Referring again to Figure 3, it is noted that for a given configuration where reception is performed in zone A and transmission in zone B, or vice versa, the terminal of the operator B differs from that of the operator A only through a simple frequency shift of 600 MHz of the harmonics generator 404, it being possible to perform this through a simple switching.

Likewise the spectral noninversion, which ensures spectral compatibility, is ensured by the spectral apportioning of the infradyne and supradyne mixers, as described hereinabove, by switching the frequencies of the generator 404 and of the synthesizer 410 and by changing two surface wave filters so as to comply with the frequency plans of the basic configurations 1 and 3; the move to configurations 2 and 4 is performed by simple shifting, as described hereinabove.

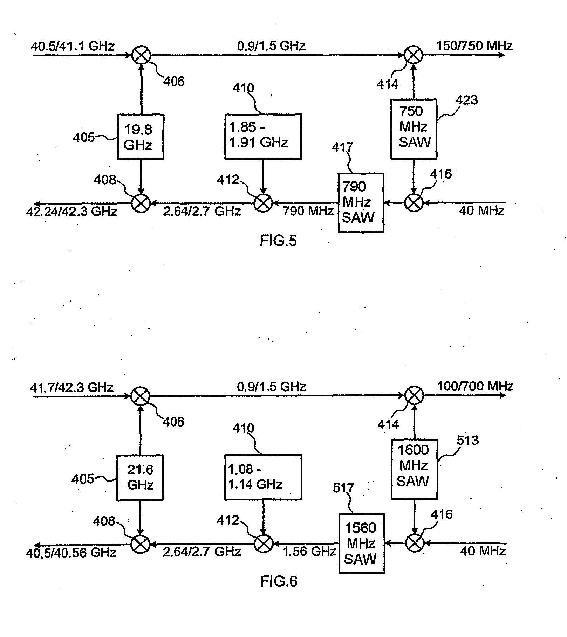

Represented in Figures 5 and 6 are the simplified schematics corresponding to these two basic configurations.

Figure 5 relates to configuration 1, which corresponds to the numerical values of Figure 4, and Figure 6 corresponds to configuration 3. Clearly, all the elements are the same, with the exception of the SAW surface wave filters 423 and 417, which are replaced by surface wave filters 513 and 517 adjusted to different frequencies. These filters are very small items and may be disposed in the apparatus right from the outset, with simple means of switching for going from one to another in the event of a change of configuration. The change of frequency at the level of the doubler 405 is performed by simple adjustment at the level of the generator 404, and that at the level of the synthesizer 410 by a simple modification of the commands originating from the bus 411.

In an exemplary embodiment of the means for generating the VHF local frequency: LOVHF and IF local frequency: LOIF, represented in Figure 7, the reference oscillator 403 energizes, in an SPD system 701, a harmonics generator 702. According to a variant embodiment (not represented), a high-frequency divider could be used to carry out this generation.

The signal output by this generator is applied to a mixer 703 which moreover receives the VHF output frequency of the assembly. The output signal from this mixer is filtered in a filter 704 whose output is applied to a voltage-controlled dielectric resonator oscillator 704 of the ETDRO (standing for Electrically Tuned Dielectric Resonator Oscillator) or VCDRO (standing for Voltage Controlled Dielectric Resonator Oscillator) type. The latter generates, with great spectral purity, the VHF local frequency. The looping back of the latter by way of the mixer 703 and of the filter 704 produces a phase loop which ensures frequency stability and spectral purity. The adjustment of the frequency is achieved by acting mechanically on the resonator so as to make it lock onto another harmonic of the harmonic generator 702. Finally, the filter 423, of SAW type, makes it possible to extract the intermediate frequency IF frequency from the output signal from the generator 702.

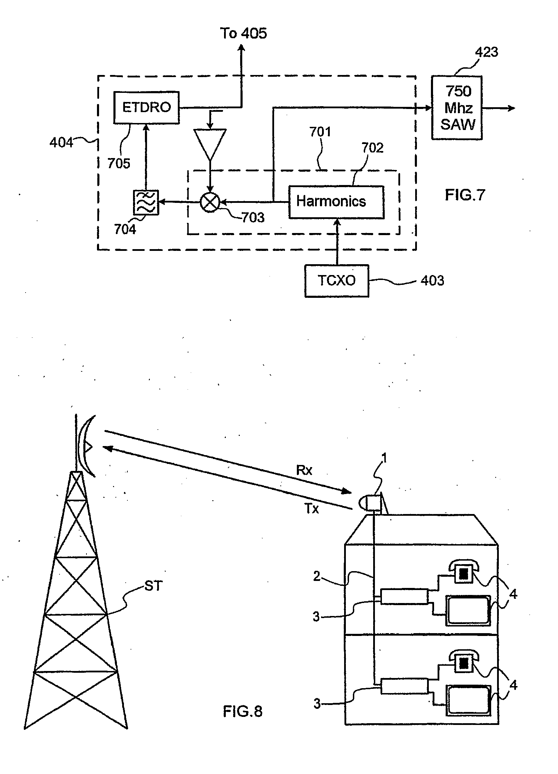

Figure 8 illustrates a distribution network system serving as relay for a cable network. A base station ST furnished with a transmitter and possibly with a receiver, broadcasts information intended for a plurality of subscribers. On the subscriber side, the unit 1 exterior to the subscriber appliances is connected to a cable network 2. A subscriber can connect up to the cable network 2 with the aid of an interior unit 3 which serves as interface for one or more user apparatuses 4.

The exterior unit 1 comprises the antenna and the VHF adapter just described and which constitutes a means for transposing the signals received into a frequency band compatible with the cable network 2 and transposing signals to be transmitted to the base station ST. The interior unit 3 is for example a TV decoder or a modem intended for the cable network 2. The user apparatus 4 is for example a television, a telephone or a computer.

To summarize, the architecture according to the invention makes it possible to obtain a DOCSIS compatible millimetre MWS ODU whose frequency stability and phase purity satisfy the constraints of the cable standard without performing any spectral inversion of the signals transmitted and received.

To this end and as has been described, the architecture uses a very stable single reference oscillator which drives means for generating the VHF and IF local frequencies common to two conversion chains, up and down, very selective surface wave filters for rejecting the local frequency at the level of the first intermediate frequency, and a frequency synthesizer which is agile in the intermediate band in the up direction.

The ODU unit proposed allows compatibility of the radio link in the 40.5-43.5 GHz band with cable appliances satisfying the very widespread DOCSIS standard. This unit allows the operator to offer a low-cost interface between a cable network and a wireless link (for example of LMDS sub-network type).

Study of the frequency plans makes it possible to show that the use of low-cost surface wave filters (SAW) from the telecommunications market (GSM or DCS) is possible.

This ODU unit also finds an application in respect of 28 GHZ LMDS systems.

## Claims

1. VHF adapter for cable network, of the type comprising a first down conversion chain and a second up conversion chain,
wherein the first chain comprises a first mixer (406) followed by a second mixer (414) and the second chain a third mixer (416) followed by a fourth (412) and by a fifth mixer (408), and wherein all the local frequencies necessary for these five mixers are obtained from a very stable single reference oscillator (403),
which drives a harmonics generator (404) inserted into a phase loop dielectric resonator oscillator (PLDRO) using a sample phase detector (SPD) system to obtain
on the one hand a first local frequency energizing the first (406) and fifth (408) mixers, and
on the other hand, with a first surface wave filter (423), a second local frequency for energizing the second (414) and the third mixers (416).

2. Adapter according to claim 1 **characterized in that** the first local frequency is obtained from the harmonics generator (404) after multiplication by two (405).

3. Adapter according to claim 1 or 2, **characterized in that** the single reference oscillator (403) furthermore drives an agile frequency synthesizer (410) controlled by a bus (411) so as to obtain variable frequencies for energizing the fourth mixer (412);
and **in that** a second surface wave filter (417) is placed between the output of the third mixer (416) and an input of the fourth mixer (412) so that, the intermediate frequency for energizing the third mixer (416) being a very low frequency pure frequency, the signal delivered by this third mixer (416) can be filtered by the second surface wave filter (417) which energetically rejects the second local frequency and the image-frequency signal.

4. Adapter according to any one of claims 1 to 3, **characterized in that** the frequencies of the harmonics generator (404) and of the agile synthesizer (410) are switchable and the surface wave filters (423, 417) are changeable.

5. Radio-frequency transmission system comprising at least one base station (ST) and at least one subscriber device, the base station (ST) using a single oscillator (403) to perform a down conversion of signals to the frequency band transmitted by radio and an up conversion of signals from the frequency band received by radio, the subscriber device comprises an interior unit (3) and an exterior unit (1) which are linked by a cable (2), **characterized in that** the exterior unit (1) comprises a VHF adapter according to one of claims 1 to 4.

## Patentansprüche

1. VHF-Adapter für ein Kabelnetz des Typs, der eine erste Abwärtsumsetzungskette und eine zweite Aufwärtsumsetzungskette umfasst,
wobei die erste Kette einen ersten Mischer (406), gefolgt von einem zweiten Mischer (414), und die zweite Kette einen dritten Mischer (416), gefolgt von einem vierten (412) und von einem fünften Mischer (408), umfasst und wobei alle für diese fünf Mischer notwendigen lokalen Frequenzen von einem sehr stabilen einzelnen Referenzoszillator (403) erhalten werden,
der einen Oberschwingungsgenerator (404) ansteuert, der in einen Oszillator mit dielektrischem Resonator und Phasenschleife (PLDRO) eingefügt ist, der ein Abtastphasendetektorsystem (SPD-System) verwendet, um Folgendes zu erhalten:
einerseits eine erste Lokalfrequenz, die den ersten (406) und den fünften (408) Mischer erregt, und
andererseits, mit einem ersten Oberflächenwellenfilter (423), eine zweite Lokalfrequenz zum Erregen des zweiten (414) und des dritten Mischers (416).

2. Adapter nach Anspruch 1, **dadurch gekennzeichnet, dass** die erste Lokalfrequenz von dem Oberschwingungsgenerator (404) nach Multiplikation mit zwei (405) erhalten wird.

3. Adapter nach Anspruch 1 oder 2, **dadurch gekennzeichnet, dass** der einzelne Referenzoszillator (403) darüber hinaus einen agilen Frequenzsynthesizer (410) ansteuert, der in der Weise durch einen Bus (411) gesteuert wird, dass variable Frequenzen zum Erregen des vierten Mischers (412) erhalten werden;
und **dadurch**, dass zwischen dem Ausgang des dritten Mischers (416) und einem Eingang des vierten Mischers (412) ein zweites Oberflächenwellenfilter (417) in der Weise angeordnet ist, dass die Zwischenfrequenz zum Erregen des dritten Mischers (416) eine sehr niederfrequente reine Frequenz ist, wobei das durch diesen dritten Mischer (416) gelieferte Signal durch das zweite Oberflächenwellenfilter (417) gefiltert werden kann, das die zweite Lokalfrequenz und das Spiegelfrequenzsignal energetisch unterdrückt.

4. Adapter nach einem der Ansprüche 1 bis 3, **dadurch gekennzeichnet, dass** die Frequenzen des Oberschwingungsgenerators (404) und des agilen Synthesizers (410) schaltbar sind und dass die Oberflächenwellenfilter (423, 417) austauschbar sind.

5. Radiofrequenz-Sendesystem, das mindestens eine Basisstation (ST) und mindestens eine Teilnehmervorrichtung umfasst, wobei die Basisstation(ST) einen einzelnen Oszillator (403) verwendet, um eine Abwärtsumsetzung von Signalen in das über Funk gesendete Frequenzband und eine Aufwärtsumsetzung von Signalen von dem über Funk empfangenen Frequenzband auszuführen, wobei die Teilnehmervorrichtung eine Inneneinheit (3) und eine Außeneinheit (1) umfasst, die durch ein Kabel (2) verbunden sind,
**dadurch gekennzeichnet, dass** die Außeneinheit (1) einen VHF-Adapter nach einem der Ansprüche 1 bis 4 umfasst.

## Revendications

1. Adaptateur hyperfréquence pour réseau câblé, du type comprenant une première chaîne de transposition descendante et une deuxième chaîne de transposition montante, pour laquelle la première chaîne comprend un premier mélangeur (406) suivi d'un deuxième mélangeur (414) et la deuxième chaîne un troisième mélangeur (416) suivi d'un quatrième (412) et d'un cinquième mélangeur (408), et pour laquelle toutes les fréquences locales nécessaires à ces cinq mélangeurs sont obtenues à partir d'un oscillateur de référence unique (403) très stable pilote un générateur d'harmoniques (404) inséré dans un oscillateur à résonateur diélectrique à boucle de phase (PLDRO) utilisant un système SPD pour obtenir d'une part une première fréquence locale d'alimentation des premier (406) et cinquième (408) mélangeurs , et d'autre part avec un premier filtre très étroit (423) une deuxième fréquence locale d'alimentation du deuxième (414) et du troisième mélangeurs (416).

2. Adaptateur selon la revendication 1, **caractérisé en ce que** la première fréquence locale d'alimentation est obtenue du générateur d'harmoniques (404) après multiplication par deux (405).

3. Adaptateur selon les revendications 1 ou 2, **caractérisé en ce que** l'oscillateur de référence unique (403) pilote en outre un synthétiseur de fréquences agile (410) commandé par un bus (411) pour obtenir des fréquences variables d'alimentation du quatrième mélangeur (412) ; **en ce qu'** un deuxième filtre (417) très étroit est placé entre la sortie du troisième mélangeur (416) et une entrée du quatrième mélangeur (412) de sorte que, la fréquence intermédiaire d'alimentation du troisième mélangeur (416) étant une fréquence pure à très basse fréquence, le signal délivré par ce troisième mélangeur (416)peut être filtré par le deuxième filtre très étroit qui rejette énergiquement la deuxième fréquence locale et le signal à fréquence image.

4. Adaptateur selon l'une quelconque des revendications 1 à 3, **caractérisé en ce que** les fréquences du générateur d'harmoniques (404) et du synthétiseur agile sont commutables et les filtres à ondes de surface (423, 417) sont échangeables.

5. Système de transmission radio-fréquence comportant au moins une station de base (ST) et au moins un dispositif abonné, la station de base (ST)utilisant un unique oscillateur (403) pour effectuer une transposition de signaux descendant vers la bande de fréquence transmise par radio et éventuellement une transposition de signaux montant depuis la bande de fréquence reçue par radio, le dispositif abonné comportant une unité intérieure (3) et une unité extérieure (1) reliées par un câble (2), **caractérisé en ce que** l'unité extérieure (1) comprend un adaptateur hyperfréquence selon l'une des revendications 1 à 4.
